# EUROPEAN PATENT APPLICATION

(11) **EP 4 726 758 A1**
(43) Date of publication of application: **15.04.2026**
(21) Application number: 24205844.4
(22) Date of filing: 10.10.2024
(51) Int. Cl.: H01H 33/02, G01R 15/18

(54) **POLE PART**

(71) Applicant: ABB SCHWEIZ AG, 5400 Baden (CH)
(72) Inventor: JANSSEN, Johannes, 44577 Castrop-Rauxel (DE); BELLUT, Markus, 40235 Düsseldorf (DE)
(74) Representative: Maiwald GmbH

(57) **Abstract**

The present invention relates to a pole part (10) for a low-voltage, medium-voltage or high voltage device. The pole part (10) comprises a pole insulating housing (14) having two terminals (18), at least one measuring device (30) is arranged in the pole insulating housing (14) and arranged in a region of a current transporting part (18b) for measuring the voltage and/or current of this current transporting part (18b). The measuring device (30) comprises a signal cable (34) arranged inside the insulating housing (14) between a signal output (38) of the measuring device (30) and an outlet (42) of the insulating housing (14). The signal cable (34) is forming between the signal output (38) of the measuring device (30) to the outlet (42) of the insulating housing (14), at least a part of a winding (50) around an axial axis (46) of the insulating housing (14) with a rotation angle (β) of at least 90°.

## Description

### FIELD OF THE INVENTION

The present invention relates to a pole part for a low-voltage, medium voltage or high-voltage device. The present invention further relates to a recloser comprising such a pole part.

### BACKGROUND OF THE INVENTION

Embedded poles are innovative structures integrated into the ground to support various applications, including electrical distribution. These poles can house essential equipment, such as transformers and communication devices, while minimizing their visual impact. Coupled with embedded voltage sensors, they offer advanced monitoring capabilities for electrical systems. Voltage sensors embedded within these poles can continuously measure voltage levels, providing real-time data that enhances grid management and reliability. This integration allows utility companies to quickly identify issues, optimize energy distribution, and improve overall system performance. Together, embedded poles and voltage sensors represent a modern approach to infrastructure.

EP 2 696 206 B1 describes a high-voltage resistor voltage divider that includes a first and a second resistor arranged along a common axis. The first resistor is connected to a high-voltage terminal, while the second resistor is connected to a ground potential terminal. A conical high-voltage electrode is directly connected to the high-voltage terminal, with part of the first resistor located within this conical shape. The design ensures that the opening of the conical electrode faces away from the high-voltage terminal, and it has a maximum diameter at the opening with a circular cross-section. Additionally, a low-voltage electrode, also conical in shape, is connected to the ground potential terminal, enhancing the device's functionality and safety in high-voltage applications.

The document EP 2 805 344 B1 describes a sensing device designed for detecting electrical parameters in low, medium, or high voltage switching devices. It includes features such as voltage detection parts configured as resistive dividers and the option for current detection using transformers. The device can be configured for both singlephase and three-phase detection, with independent detection mechanisms for each phase. Additionally, it can be integrated with disconnection apparatuses, such as circuit breakers, positioned near the pole-forming part containing the breaker. The patent emphasizes the device's versatility and efficiency in monitoring electrical systems.

### SUMMARY OF THE INVENTION

The problem to be solved by the present invention is to provide pole part having reduced risk of discharges and having low manufacturing costs.

The problem is solved by a pole part having the features of claim 1. Preferred embodiments of the invention are specified in the dependent claims.

According to the invention a pole part for a low-voltage, medium-voltage or high voltage device is proposed. The pole part comprises a pole insulating housing having two terminals, at least one measuring device is arranged in the pole insulating housing and arranged in a region of a current transporting part for measuring the voltage and/or current of this current transporting part. The measuring device comprises a signal cable arranged inside the insulating housing between a signal output of the measuring device and an outlet of the insulating housing. The signal cable is forming between the signal output of the measuring device to the outlet of the insulating housing, at least a part of a winding around an axial axis of the insulating housing with a rotation angle of at least 90°.

The signal output of the measuring device is a position, where the signal cable is connected to a housing of the measuring device. The signal cable thereby is used to transmit the measurement signal via the outlet of the insulating housing to an outer side of the pole part. Wherein the outlet of the insulating housing is the position of the insulating housing, where the signal cable leaves the insulating housing. In contrast to the state-of-the-art, where the signal cable is arranged parallel to the axial axis, the present invention forms between the signal output of the measuring device and the outlet of insulating housing a part of a winding. The winding is a circular arrangement of the signal cable in the insulating housing. The axial axis, which is parallel to the extension of the insulating housing is forming a centre of the winding.

With such a winding a distance along the signal cable between the output of the measuring device and the outlet of the insulating housing is increased. As the signal cable has a low or ground potential with respect to the terminals, an electric field follow the signal cable on an inner surface side of the insulating housing to the outside of the insulating housing. By increasing the distance between the output of the measuring device and the outlet of insulating housing the electric field has to follow a longer distance to the outer side of the insulating housing. In other words, the electric field will follow the signal cable along the winding. However, during this longer distance the electric field is fully diminished, so that the insulating effect is increased, and the risk of electric discharges on an outer side of the insulating housing is decreased. Further, as such a winding can be provided without increasing the manufacturing costs, the electric discharges can be decreased while having low manufacturing costs for the pole part.

In a preferred embodiment of the invention, a cable guidance is provided for the signal cable, guiding the signal cable in the insulating housing. A cable guidance according to the present invention is part of the insulating housing or a separate part which already has the required shape for the signal cable. Therefore, the guidance simplifies to bring the signal cable in the required shape. Apart from this, it is also possible providing the signal cable to the insulating housing on a later stage of the manufacturing process of the pole part. In a preferred embodiment the guidance is provided as a separate hose.

In a further preferred embodiment, the cable guidance is a 3D printed plastic part. A 3D printed plastic part has the advantage that the required winding shape of the signal cable can easily manufacture. By manufacturing the cable guidance with a 3D printing method it can be quickly changed between different shapes of the guidance. Therefore, the manufacturing costs for the guidance can be decreased. Preferably, the guidance is made of in insulated material. Thereby the risks of discharges in the area of the signal cable are reduced.

Advantageously, the signal cable has a stiffness so that it can be plastically deformed into the winding shape. After the signal cable has been plastically deformed into the winding shape, the signal cable remains in this shape. Accordingly, no guidance is required to provide the signal cable in the required winding shape. Therefore, it is possible to omit a guidance, so that manufacturing costs of the pole part can be further decreased. The stiffness thereby either is provided by a wire of the signal cable, by an insulation of the signal cable or by an additional wire provided together with the signal cable.

Preferably, the signal cable and/or the cable guidance is molded in the insulating housing. In other words, the signal cable and/or the cable guidance is molded into the insulating material of the insulating housing. By embedding the signal cable respectively, the cable guidance into the insulating material, the signal cable is insulated via the insulation material so that no additional insulation is necessary for the signal cable. Further, it is easier to bring and maintain the signal cable in the required winding shape. Apart from this it can be prevented that electric discharges occur.

In a further advantageous development, the rotation angle of the winding is at least 180° or 360°. By using the rotation angle between 180° or 360° the distance between the output of the measuring device and the outlet of the insulating housing is further increased. Therefore, the risk of electric discharges is further decreased. By using such rotation angle, it is further possible reducing the axial length of the insulating housing. Preferably, the rotation angle of the winding is between 360° and 720°. With such a rotation angle the risk of electric discharges further can be decreased.

In a preferred embodiment, the winding is arranged on the same height in the insulating housing. The winding therefore does not have an axial component. An arrangement of the winding on the same height has the advantage, that it is possible influencing the electrical field, while the required space for the winding can be reduced. Therefore, it is possible providing such a winding also in small pole insulating housings.

A preferred embodiment specifies that the winding is formed in a helical shape. A winding having a helical shape also has an axial component. In contrast to the winding, which is arranged on the same height, with this winding a more homogeneous electrical field distribution can be achieved. The electrical field along the axial direction therefore is almost the same. Such a homogeneous electrical field has the advantage that risks for electrical discharges can be reduced. Further, it is possible to achieve a lower maximal electrical field strength compared to the arrangement of the winding at the same height.

Preferably, the winding has a varying diameter. The winding diameter therefore is not constant but changes. By providing a winding with a varying diameter it also possible using oval shaped insulating housing, so that also the winding forms ovals. A varying diameter of the winding further has the advantage, that it is possible regulating the electrical field by either using a larger of a smaller diameter of the winding. The field thereby can be regulated that the electrical field is homogenous. With such a homogenous electrical field the risk for electrical discharges can be decreased.

In a preferred embodiment, the signal cable provides at least two cable sections, which are arranged directed in an axial direction of the insulating housing, wherein these sections are arranged in the insulating housing with an angular offset to each other. Between both sections the cable section with the winding is arranged. An angular offset has to be understood that both sections are positioned on a different circumferential position of the insulating housing. Both positions include a circumferential angle, which is described as the angular offset. With such an arrangement the electric field is forced to follow the winding, so that a shortcut of the way is prevented. The risk of electric discharges therefore can be decreased while the safety is increased.

Advantageously, the measuring device is a sensor or transformer. A sensor and a transformer having different advantages with respect to the measurement accuracy, the costs and the required space. By maintaining the option using both types of measuring devices, one of both measuring devices can be chosen which fits best to the requirements.

In a further embodiment, the pole insulating housing is made of an epoxy material. Epoxy material has the advantage of a very high dielectric strength. These materials further provide very good insulation properties even with thin walls. Accordingly, by using epoxy material a small and light weighted pole part can be provided.

Further, the recloser is proposed comprising a pole part according to the invention. Such a recloser comprises the aforementioned characteristic features and advantages.

The above aspects and examples will become apparent from and be elucidated with reference to the embodiments described hereinafter.

### BRIEF DESCRIPTION OF THE DRAWINGS

The subject matter of the Invention will be explained in more details in the following description illustrated in the drawings, in which:
- Figure 1: Longitudinal sectional view of a pole part according to a first embodiment of the present invention,
- Figure 2: Longitudinal sectional view of the pole part according to a second embodiment of the present invention,
- Figure 3: Cross-sectional view of the pole part according to figure 2, and
- Figure 4: Longitudinal section view of the pole part according to a third embodiment of the invention.

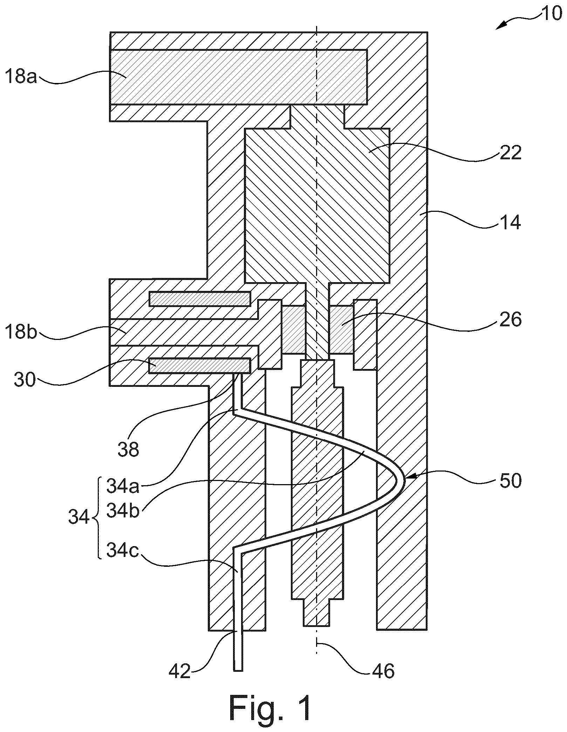

Figure 1 shows a longitudinal section view of a pole part 10 according to a first embodiment of the present invention. The pole part 10 comprises a pole insulating housing 14, which is made of an epoxy material. Further, the pole part 10 comprises two terminals 18a, 18b, which is an upper terminal 18a and a lower terminal 18b, arranged in the insulating housing 14. Between the upper and the lower terminal 18a, 18b a vacuum interrupter 22 is arranged. The lower terminal 18b is connected to the vacuum interrupter via a movable contact 26. Inside the insulating housing 14 a measuring device 30 is arranged in a region of the lower terminal 18b, which is a current transporting part of the pole part 10. The measuring device 30 is used for measuring the voltage and current of this terminal 18b.

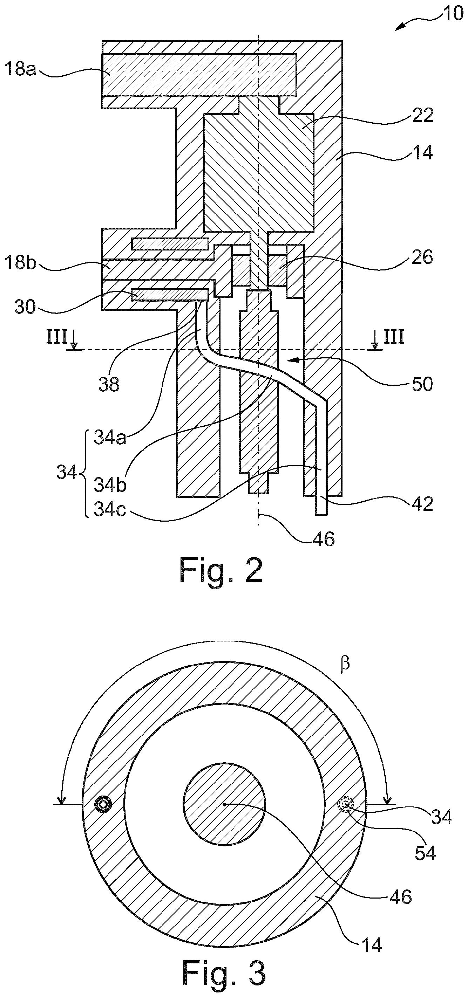

The measuring device 30 further comprises a signal cable 34 for transporting the measurement signal. The signal cable 34 is arranged between a signal output 38 of the measurement device 30 to an outlet 42 of the insulating housing 14. As the signal cable 34 outside the insulating housing 14 is connected to a signal receiving device (not shown), the signal cable 34 has a low or ground potential. Figure 1 further shows that not all sections 34a, 34b, 34c of the signal cable 34 are directed parallel to an axial axis 46 of the insulating housing 14. From the signal output 38 of the measuring device 30 the signal cable 34 comprises a first section 34a directed in an axial direction. After this first section 34a, the signal cable 34, in a second section 34b, is forming a part of a winding 50 around the axial axis 46 of the insulating housing 14. This winding 50 thereby comprises a rotation angle β (see figure 3) of 360°. After the winding 50, a third section 34c of the signal cable 34 is provided, also directed in an axial direction of the insulating housing 14.

In figure 2 a second embodiment of the pole part 10 is shown. This embodiment thereby differs to the embodiment in figure 1 thereby, that the signal cable 34 between the signal output 38 of the measuring device 30 and the outlet 42 of the insulating housing 14 is arranged with the winding 50 having a rotation angle β of 180° (see figure 3). In this embodiment the two cable sections 34a, 34c, arranged in an axial direction, are therefore arranged with an angular offset of 180°.

Figure 3 shows a cross-sectional view of the pole part 10 according to figure 2. In this figure it is shown that the signal cable 34 is arranged inside a guidance 54 which is embedded in the insulation material of the insulating housing 14. With the guidance 54 it is possible to introduce the sensor cable 34 after the insulating housing 14 has been manufactured.

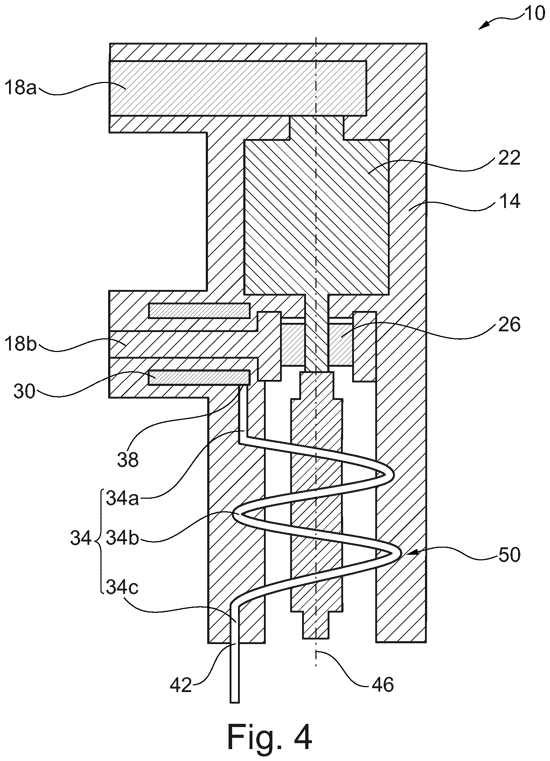

Figure 4 shows a third embodiment of the pole part 10. This embodiment differs to the embodiment of figure 1 and 2 in that the winding 50 of the signal cable 34 has a rotation angle β of 720°. The winding 50 thereby is formed in a helical manner. By arranging the signal cable 34 in a helical manner, the electric field distribution is controlled so that the risk of discharges in this area is decreased. With this arrangement of the signal cable 34, it is possible to omit field control elements, controlling the electric field distribution. Further, the wall thickness of the insulating housing 14 can be decreased so that less space for the insulating housing 14 and material is required.

### List of reference numbers

- 10: pole part
- 14: insulating housing
- 18a: upper terminal
- 18b: lower terminal
- 22: vacuum interrupter
- 26: Movable contact
- 30: measuring device
- 34: signal cable
- 34a: first section signal cable
- 34b: second section signal cable
- 34c: first section signal cable
- 38: signal output of measuring device
- 42: outlet insulating housing
- 46: Axial axis
- 50: winding
- 54: guidance
- β: rotation angle

## Claims

1. Pole part (10) for a low-voltage, medium-voltage or high voltage device, comprising a pole insulating housing (14) having two terminals (18a, 18b), at least one measuring device (30) is arranged in the pole insulating housing (14), and arranged in a region of a current transporting part (18b) for measuring the voltage and/or current of this current transporting part (18b), wherein the measuring device (30) comprises a signal cable (34) arranged inside the insulating housing (14) between a signal output (38) of the measuring device (30) and an outlet (42) of the insulating housing (14), wherein
the signal cable (34) is forming between the signal output (38) of the measuring device (30) to the outlet (42) of the insulating housing (14), at least a part of a winding (50) around an axial axis (46) of the insulating housing (14) with a rotation angle (β) of at least 90°.

2. Pole part (10) according to claim 1, **characterized in that** a cable guidance (54) is provided for the signal cable (34), guiding the signal cable (34) in the insulating housing (14).

3. Pole part (10) according to claim 2, **characterized in that** the cable guidance (54) is a 3D printed plastic part.

4. Pole part (10) according to one of the preceding claims, **characterized in that** the signal cable (34) has a stiffness so that it can be plastically deformed into the winding shape.

5. Pole part (10) according to one of the claims 2 to 4, **characterized in that** the signal cable (34) and/or the cable guidance (54) is molded in the insulating housing (14).

6. Pole part (10) according to one of the preceding claims, **characterized in that** the rotation angle (β) of the winding (50) is at least 180° or 360°.

7. Pole part (10) according to one of the preceding claims, **characterized in that** the winding (50) is arranged on the same height in the insulating housing (14).

8. Pole part (10) according to claims 1 to 6, **characterized in that** the winding (50) is formed in a helical shape.

9. Pole part (10) according to one of the preceding claims, **characterized in that** the winding (50) has a varying diameter.

10. Pole part (10) according to one of the preceding claims, **characterized in that** the signal cable (34) provides at least two cable sections (18a, 18c), which are arranged directed in an axial direction of the insulating housing (14), wherein these sections (18a, 18c) are arranged in the insulating housing (14) with an angular offset to each other.

11. Pole part (10) according to one of the preceding claims, **characterized in that** the measuring device (30) is a sensor or transformer.

12. Pole part (10) according to one of the preceding claims, **characterized in that** the pole insulating housing (14) is made of an epoxy material.

13. Recloser comprising a pole part (10) according to one of the preceding claims.
